Europäisches Patentamt

European Patent Office

Office européen des brevets

(19)

(11) Veröffentlichungsnummer: **0 160 720**
**B1**

(12) **EUROPÄISCHE PATENTSCHRIFT**

(45) Veröffentlichungstag der Patentschrift:
**07.01.88**

(21) Anmeldenummer: **84105116.2**

(22) Anmeldetag: **07.05.84**

(51) Int. Cl.⁴: **H 01 L 29/60**, G 11 C 17/00,
**G 06 F 11/20**

(54) Halbleiterspeicherzelle mit einem potentialmässig schwebenden Speichergate.

(43) Veröffentlichungstag der Anmeldung:
**13.11.85 Patentblatt 85/46**

(45) Bekanntmachung des Hinweises auf die Patenterteilung:
**07.01.88 Patentblatt 88/1**

(84) Benannte Vertragsstaaten:
**DE FR NL**

(56) Entgegenhaltungen:
**EP - A - 0 053 075**

**ELECTRONICS INTERNATIONAL, Band 55, Nr. 3, Februar 1982, Seiten 121-125, New York, USA; A. GUPTA et al.: "5V only EE-PROM-springboard for autoprogrammable systems"**
**IBM TECHNICAL DISCLOSURE BULLETIN, Band 20, Nr. 9, Februar 1978, Seiten 3490-3491, Armonk, New York, USA; R.C. DOCKERTY: "Depletion-mode FAMOS device"**

(73) Patentinhaber: **Deutsche ITT Industries GmbH, Hans-Bunte-Strasse 19 Postfach 840, D-7800 Freiburg (DE)**

(72) Erfinder: **Adam, Fritz Günther, Dr. rer.nat., Dipl.-Phys., Furtwänglerstrasse 10, D-7800 Freiburg i. Br. (DE)**

(74) Vertreter: **Morstadt, Volker, Dipl.-Ing. et al, c/o Deutsche ITT Industries GmbH Patent/Lizenzabteilung Postfach 840 Hans-Bunte-Strasse 19, D-7800 Freiburg/Brsg. (DE)**

## Beschreibung

Bei der Herstellung von Speichermatrizen mit Speicherzellen, welche elektrisch umprogrammierbare Isolierschicht-Feldeffekt-Speichertransistoren enthalten, besteht ein schwerwiegendes Problem hinsichtlich der Ausbeute bei der Herstellung insofern, als im Prinzip nur solche Speichermatrizen verwendbar sind, deren sämtliche Speicherzellen einwandfrei sind. Man hat dieses Problem beispielsweise nach der internationalen Anmeldung WO-A-83/02847 dadurch zu lösen versucht, dass redundante Spalten vorgesehen sind, welche nach Feststellung einer oder mehrerer fehlerhaften Zellen in einer Spalte anstelle der defekten Spalte unter Verwendung eines programmierbaren Redundanzdekoders geschaltet werden. Aus der EP-A-0 098 079 ist auch bekannt, bei solchen Speichermatrizen einen elektrisch programmierbaren Redundanzdekoder vorzusehen, der entsprechend seiner Programmierung eine defekte Speicherzelle bei der Anwahl durch eine einwandfreie Speicherzelle ersetzt.

Solche Massnahmen zur Lösung des erwähnten Problems erfordern jedoch einen zusätzlichen Peripherieschaltungsaufwand sowie ein Durchmessen der Speichermatrix und ein Programmieren der Schaltungsmittel, die einen Ersatz einer defekten Zelle durch eine redundante fehlerfreie bewirken.

Die Erfindung geht zur Behebung dieser Nachteile von dem Gedanken aus, eine Speicherzelle mit einer «inneren» Redundanz anzugeben, d.h. eine Speicherzelle, welche die Fähigkeit besitzt, ihre Speichereigenschaft beim Auftreten eines Fehlers in der das Speichermedium umgebenden Isolierschicht, insbesondere eines Fehlers des Injektoroxides zwischen dem Halbleitersubstrat und dem Speichergate (Floating-Gate), zu behalten, ohne dass es des Aufwandes eines peripheren Redundanzdekoders und der Umadressierung zum Ersatz einer fehlerhaften Speicherzelle gegen eine einwandfreie redundante Zelle bedarf. Eine solche Speicherzelle würde nicht nur die Ausbeute an funktionsfähigen Speichermatrizen erhöhen, sondern auch die Zyklenfestigkeit verbessern, da auch dann die Speicherfähigkeit der Zelle erhalten bleibt, wenn lokale Defekte in der Zelle im Laufe der Betriebszeit auftreten.

Die Erfindung betrifft eine Halbleiterspeicherzelle mit einem potentialmässig schwebenden Speichergate, welches mittels eines Ladungsinjektors umladbar ist und sich über die Kanalzone eines Speichertransistors erstreckt, dessen Source-Drain-Strecke in Reihe zur Source-Drain-Strecke eines Auswahltransistors zwischen einer ersten Bitleitung und einer zweiten Bitleitung einer Speichermatrix liegt, gemäss dem Oberbegriff des Anspruchs 1.

Derartige Speicherzellen sind beispielsweise aus der Zeitschrift «Electronics» vom 10.2.1982, Seiten 121 bis 125 und der Zeitschrift «IBM Technical Disclosure Bulletin» 23/2 (Juli 1980) Seiten 661 bis 663, bekannt.

Aufgabe der Erfindung ist, die Ausbeute und die Zyklenfestigkeit von integrierten Speichermatrizen mit derartigen Speicherzellen zu verbessern.

Diese Aufgabe wird erfindungsgemäss durch die im kennzeichnenden Teil des Anspruchs 1 angegebene Ausbildung gelöst.

Die Halbleiterspeicherzelle nach der Erfindung unterscheidet sich also von den bekannten Speicherzellen zunächst dadurch, dass anstelle eines einzelnen Speichertransistors eine Source-Drain-Reihenschaltung von solchen Speichertransistoren vorgesehen ist, deren Programmiergates an der Programmierleitung liegen. Die Kanalbereiche der Speichertransistoren zwischen den Source-Drain-Zonenpaaren werden mit Verunreinigungsatomen vom Leitungstyp der Zonen derart dotiert, beispielsweise durch maskierte Ionenimplantation, dass die Speichertransistoren vom Verarmungstyp sind. Damit wird erreicht, dass beim Ausfall eines Speichertransistors infolge eines Durchschlages im Injektoroxid dieser Speichertransistor zwar nicht mehr programmierbar ist, jedoch leitend bleibt, so dass die betroffene Speicherzelle als ganzes unverändert programmierbar bleibt.

Vorteilhafte Ausführungsformen der Erfindung werden in den abhängigen Ansprüchen angegeben.

Bei einer bevorzugten Ausführungsform der Speicherzelle nach der Erfindung sind die Injektoren der Speicherzelle nur über die Source-Drain-Strecke eines Injektor-Auswahltransistors ansteuerbar. Dies hat unter anderem den Vorteil, dass Störungen der auf dem Speichergate der Speicherzelle gespeicherten Ladung während eines Lesezykluses ausgeschlossen sind, da eine Verbindung zwischen den Injektoren und der ersten Bitleitung nicht existiert. Die Gate-Elektrode des Injektor-Auswahltransistors wird vorzugsweise ebenfalls mit der Wortleitung der Halbleiterspeicherzelle verbunden.

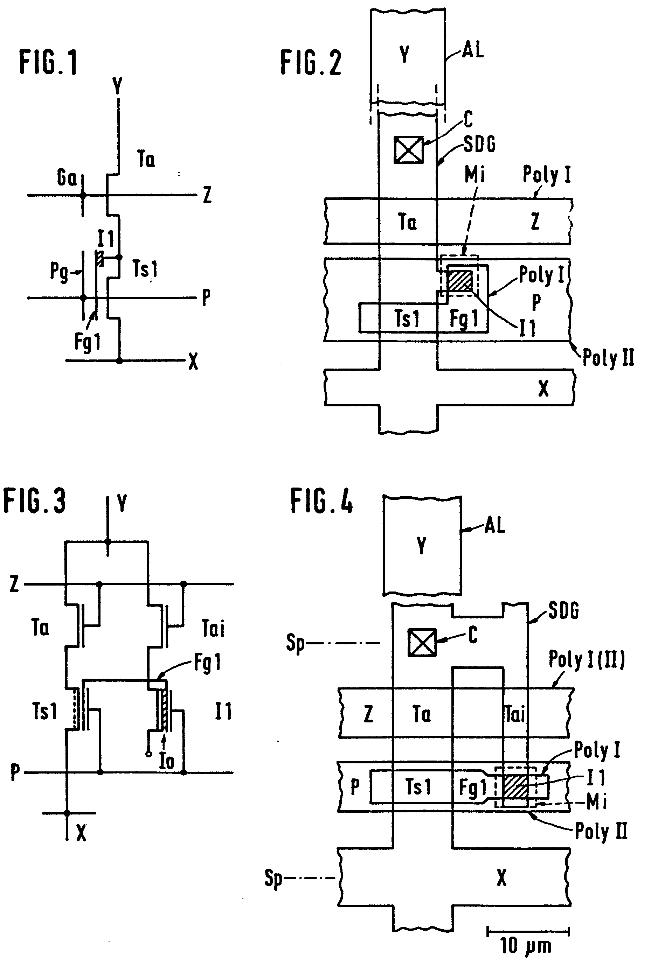

Die Erfindung und ihre Vorteile werden im folgenden anhand der Zeichnung erläutert,

deren Fig. 1 das Schaltbild einer bekannten Halbleiterspeicherzelle mit einem potentialmässig schwebenden Speichergate zeigt,

deren Fig. 2 deren Auslegung darstellt,

deren Fig. 3 das Schaltbild einer weiteren bekannten Halbleiterspeicherzelle mit einem potentialmässig schwebenden Speichergerät zeigt.

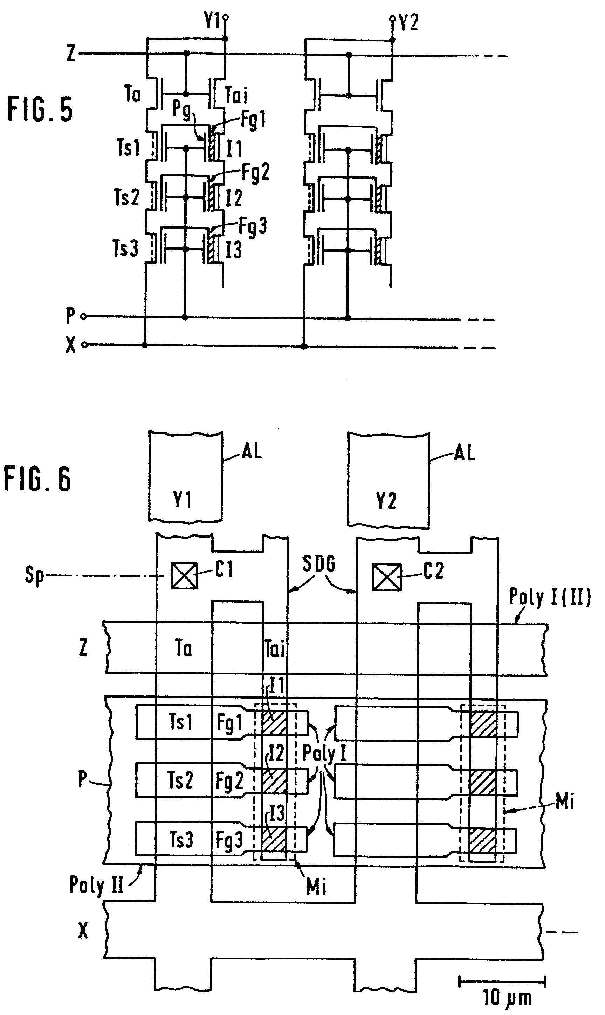

deren Fig. 4 die Auslegung der Halbleiterspeicherzelle nach der Fig. 3 zur Darstellung bringt,

deren Fig. 5 als Ausschnitt einer Speichermatrix zwei Halbleiterspeicherzellen nach der Erfindung zeigt und in

deren Fig. 6 die Auslegung des Speichermatrizenausschnittes der Fig. 5 dargestellt ist.

Die Fig. 1 zeigt das Schaltbild einer bekannten Halbleiterspeicherzelle, welche in Source-Drain-Reihenschaltung zwischen der ersten Bitleitung X und der zweiten Bitleitung Y den Speichertransistor Ts1 und den Auswahltransistor Ta enthält. Die Gateelektrode Ga des Auswahltransistors Ta ist mit der Wortleitung Z verbunden, über die die Auswahltransistoren einer Zelle der Speichermatrix angesteuert werden können und dadurch in Verbindung mit geeigneten Potentialen an den Bitleitungen X und Y das Lesen, Schreiben oder auch Löschen einer einzelnen Speicherzelle möglich ist. Der Speichertransistor Ts1 enthält das potentialmässig schwebende Speichergate Fg1, welches über den Injektor I1 geladen oder entladen werden kann. Zwischen dem Speichergate Fg1 torelektrode findet sich das in der Fig. 1 schematisch schraffierte Gateoxid, dessen Dicke etwa zwischen 5 und 15 mm (50 und 150 Å) liegt, so dass es von Elektronen durchtunnelt werden kann. Das Speichergate Fg1 kann kapazitiv über die Programmierelektrode Pg zum Schreiben oder Löschen angesteuert werden, wobei das erforderliche Potential an die Programmierleitung P angelegt wird.

Die Fig. 2 zeigt die Si-Gate-Auslegung der bekannten Speicherzelle gemäss der Fig. 1, die sich durch Verwendung von zwei Leiterebenen aus polykristallinem Silizium auszeichnet. Aus diesem werden die mit Poly-I bezeichnete Wortleitung Z und die ebenfalls mit Poly-I bezeichnete Elektrode Fg1 ausgeätzt. Das Herstellungsverfahren beginnt jedoch mit dem Prozess zur Herstellung des mit einem Feldoxid bedeckten Feldbereiches ausserhalb der SDG-Bereiche der ersten Maske, innerhalb deren Begrenzung dann die Halbleiteroberfläche zunächst freigelegt wird. Anschliessend wird die freigelegte Substratoberfläche zur Herstellung des Gateoxides oxidiert. Unter Verwendung einer die Tunneloxidbereiche enthaltenden zweiten Maske Mi wird sodann der schraffierte Bereich der Fig. 2 freigelegt und das Tunneloxid des Injektors I1 in der erforderlichen Dicke erzeugt. Daraufhin erfolgt der bereits erwähnte Poly-I-Prozess mit der Abgrenzung der Wortleitung Z des Speichergates Fg1 . Anschliessend wird das Gateoxid in den von dem polykristallinen Silizium nicht bedeckten Bereichen entfernt, so dass bei dem folgenden Implantations- und/oder Diffusionprozess die dotierten Sourcezonen bzw. Drainzonen entstehen. Auf das oxidierte polykristalline Silizium und das vom Feldoxid bedeckte Grundmaterial wird nun eine zweite polykristalline Siliziumschicht aufgebracht, aus der unter Verwendung der mit Poly-II bezeichneten Maske die Programmierleitung P herausgeätzt wird. Diese bedeckt, wie die Fig. 2 veranschaulicht, das Speichergate Fg1, wodurch die erforderliche kapazitive Kopplung gegeben ist. Die Fig. 2 veranschaulicht ebenfalls, dass gleichzeitig mit den Zonen die erste Bitleitung X aufgrund der Formgebung der SDG-Maske diffundiert wurde, welche an der Stelle C mit der in Form einer Aluminiumleitbahn Al kontaktierten Zone des Auswahltransistors Ta kontaktiert wird. Im übrigen verläuft die zweiten Bitleitung Y quer zu sämtlichen Wortleitungen Z und Programmierleitungen P der Speichermatrix, wie aus der Fig. 2 offensichtlich ist. Das vorstehend geschilderte Herstellungsverfahren ist in gleicher Weise auf die Auslegungen der Fig. 4 und 6 anwendbar.

Fig. 3 zeigt das Schaltbild einer weiteren bekannten Halbleiterspeicherzelle mit einem potentialmässig schwebenden Speichergate Fg1, wie sie aus der eingangs genannten Literaturstelle «Electronics» vom 10.2.1982 bekannt war. Bei dieser Speicherzelle ist das Tunneloxid des Injektors I1 von der ersten Bitleitung X, an die beim Lesen etwa 2 V angelegt wird, elektrisch getrennt. Da gleichzeitig sowohl an der zweiten Bitleitung Y als auch an der Wortleitung Z das Nullpotential anliegt, werden die Tunneloxide der nichtangewählten Speicherzellen während eines Lesezyklus nicht belastet.

Die Auslegung der Speicherzelle gemäss der Fig. 3 in einer Speichermatrix in der bekannten Si-Gate-Technik erfolgt entsprechend der Fig. 4. Dabei werden die Speicherzellen symmetrisch zu den Symmetrielinien Sp angeordnet.

Ausgehend von der Halbleiterspeicherzelle gemäss den Fig. 3 und 4 wird im folgenden das bevorzugte Ausführungsbeispiel der Halbleiterspeicherzelle nach der Erfindung gemäss den Fig. 5 und 6 beschrieben. In diesen Figuren sind als Ausschnitt einer Speichermatrix zwei Speicherzellen nach der Erfindung, zunächst als Ersatzschaltbild der Fig. 5 und dann die Auslegung gemäss der Fig. 6, angegeben.

Wie die Fig. 6 erkennen lässt, ergibt sich dabei eine besonders platzsparende Auslegung, da die Injektoren I1, I2 und I3 lediglich Teile von zwei parallel verlaufenden streifenförmigen Bereichen der nach der SDG-Maskierung erfolgenden Dotierungen der freiliegenden Halbleiteroberfläche einnehmen. Diese parallel verlaufenden Bereiche, welche sich in die erste Bitleitung X fortsetzen, werden an ihren Längsseiten von der ausserhalb der Bereiche der SDG-Maskierung eingenommenen Feldoxidschicht begrenzt.

Bei dem Ausführungsbeispiel der Fig. 5 und 6 handelt es sich um eine Dreifach-Speicherzelle, wobei zwei der Speichertransistoren redundant sind. Jeder der Speichertransistoren Ts1, Ts2 und Ts3 und der jeweils daneben liegende Injektor I1, I2 bzw. I3 besitzen ein ihnen gemeinsames eigenes schwebendes Speichergate. Selbstverständlich können anstelle von zwei redundanten Speichertransistoren jede beliebige Anzahl, beispielsweise lediglich eine oder auch mehr als zwei redundante Speichertransistoren mit zugehörigen Injektoren vorgesehen werden, wobei der Platzaufwand im Verhältnis zur Zuverlässigkeit in Erwägung zu ziehen ist. Dieser zusätzliche Platzaufwand von redundanten Speichertransistoren bleibt aber weitgehend unerheblich, da zusätzliche Steuerleitungen und Steuerlogik einschliesslich der nach dem bekannten Stand der Technik erforderlichen Redundanzdekoder nicht benötigt werden.

Die Funktionsweise einer Halbleiterspeicherzelle nach der Erfindung besteht darin, dass durch einen Defekt einer Teilzelle der Speicherzelle infolge eines Durchschlags im Injektoroxid das Speichergate Fg1, Fg2 bzw. Fg3 der betroffenen Teilzelle mit der zweiten Bitleitung Y kurzgeschlossen wird und die Teilzelle damit nicht mehr programmierfähig ist. Der zugehörige Speichertransistor Ts1, Ts2 bzw. Ts3 bleibt aber leitend, da entsprechend der Erfindung der Verarmungstyp sämtlicher Speichertransistoren Ts1, Ts2 und Ts3 vorgesehen ist. Zu diesem Zwecke werden in die Gatebereiche der Speichertransistoren Dotierungen vom Leitungstyp der Source/Drain-Zonen mittels einer maskierten Ionenimplantation eingeführt. Für die Funktionsweise der Speicherzelle nach der Erfindung genügt es also, wenn wenigstens eine der in Serie liegenden Teilzellen defektfrei und damit programmierfähig bleibt. Damit wird die Ausbeute funktionsfähiger Speicher erheblich gesteigert.

## Patentansprüche

1. Halbleiterspeicherzelle mit einem potentialmässig schwebenden Speichergate (Fg1), welches mittels eines Ladungsinjektors (I1) umladbar ist und sich über die Kanalzone eines Speichertransistors (Ts1) erstreckt, dessen Source-Drain-Strecke in Reihe zur Source-Drain-Strecke eines Auswahltransistors (Ta) zwischen einer ersten Bitleitung (X) und einer zweiten Bitleitung (Y) einer Speichermatrix liegt, wobei

– das Speichergate (Fg1) kapazitiv an ein Programmiergate (Pg) angekoppelt ist, welches an einer Programmierleitung (P) einer Speichermatrix liegt und

– die Gateelektrode (Ga) des Auswahltransistors (Ta) mit einer Wortleitung (Z) der Speichermatrix verbunden ist,
dadurch gekennzeichnet,

– dass zwischen der ersten Bitleitung (X) und der zweiten Bitleitung (Y) in Reihe zur Source-Drain-Strecke des Speichertransistors (Ts1) die Source-Drain-Strecke mindestens eines weiteren Speichertransistors (Ts2 . . . Tsn) mit einem eigenen, schwebenden Speichergate (Fg2 . . . Fgn) liegt, das über einen eigenen Injektor (I2 . . . In) umladbar ist,

– dass die Speichertransistoren (Ts1 . . . Tsn) vom Verarmungstyp sind und

– dass die Programmiergates (Pg) der Speichertransistoren (Ts1 . . . Tsn) über die Programmierleitung (P) miteinander zusammenhängend ausgebildet und Teil der gemeinsamen Programmierleitung (P) sind.

2. Halbleiterspeicherzelle nach Anspruch 1, dadurch gekennzeichnet, dass die Injektoren (I1 . . . I2 . . . In) der Speicherzelle über die Source-Drain-Strecke eines Injektor-Auswahltransistors (Tai) ansteuerbar sind.

3. Halbleiterspeicherzelle nach Anspruch 2, dadurch gekennzeichnet, dass die Gateelektrode des Injektor-Auswahltransistors (Tai) mit einer Wortleitung (Z) verbunden ist.

4. Halbleiterspeicherzelle nach Anspruch 3, dadurch gekennzeichnet, dass die Injektoren (I1,I2 . . . In) in Serie liegen und von der Serienschaltung der Speichertransistoren (Ts1 . . . Tsn) durch einen schmalen Streifen Feldoxid getrennt sind.

## Claims

1. Semiconductor memory cell comprising an electrically floating gate (Fg1) which is rechargeable with the aid of a charge injector (I1), and extends throughout the channel region of a memory transistor (Ts1) whose source-drain region is connected in series with the source-drain region of a selection transistor (Ta) between a first bit line (X) and a second bit line (Y) of a memory matrix, with

– the floating gate (Fg1) being capacitively coupled with a programming gate (Pg) which is connected to a programming line (P) of a memory matrix, and

– the gate electrode (Ga) of the selection transistor (Ta) being connected with a word line (2) of the memory matrix,

characterized in

– that between the first bit line (X) and the second bit line (Y) in series with the source-drain region of the memory transistor (Ts1) there is disposed the source-drain region of at least one further memory transistor (Ts2 . . . Tsn) with a floating gate of its own (Fg2 . . . Fgn), which is rechargeable via an injector (I2 . . . In) of its own,

– that the memory transitors (Ts1 . . . Tsn) are of the depletion type, and

– that the programming gates (Pg) of the memory transistors (Ts1 . . . Tsn) are linked with one another and form part of the common programming line (P).

2. A semiconductor memory cell as claimed in claim 1, characterized in that the injectors (I1, I2 . . . In) of the memory cell are selectable via the source-drain region of an injector selection transistor (Tai).

3. A semiconductor memory cell as claimed in claim 2, characterized in that the gate electrode of the injector selection transistor (Tai) is connected to a word line (Z).

4. A semiconductor memory cell as claimed in claim 3, characterized in that the injectors (I1, I2 . . . In) are arranged in series, and are separated from the series arrangement of the memory transistors (Ts1 . . . Tsn) by a narrow strip of field oxide.

## Revendications

1. Cellule de mémoire à semi-conducteur comprenant une grille électriquement flottante (Fg1) qui est rechargée à l'aide d'un injecteur de charges (I1) et s'étend sur toute le trajet de canal d'un transistor de mémoire (Ts1) dont le trajet source-drain est connectée en séries avec le trajet source-drain d'un transistor de sélection (Ta), entre une première ligne de bit (X) et une deuxième ligne de bit (V) d'une matrice de mémoire dans laquelle:

– la grille flottante (Fg1) est couplée capacitivement à une grille de programmation (Pg), qui est connectée à une ligne de programmation (P) d'une matrice de mémoire et

– l'électrode de grille (Ga) du transistor de sélection (Ta) est connectée à une ligne de mot (Z) de la matrice de mémoire,
caractérisé en ce que

– entre la première ligne de bit (X) et la deuxième ligne de bit (Y), en série avec le trajet source-drain du transistor de mémoire (Ts1) est interposé le trajet source-drain d'au moins un transistor de mémoire additionnel (Ts2 . . . Tsn) ayant une grille flottante en propre (Tg2 . . . Fgn) rechargeable par un injecteur (I2 . . . In) qui lui est propre,

– les transistors de mémoire (Ts1 . . . Tsn) sont des transistors à appauvrissement, et

– les grilles de programmation (Pg) des transistors de mémoire (Ts1 . . . Tsn) sont réalisées sur les lignes de programmation (P) les reliant et sont une partie de la ligne de programmation commune (P).

2. Cellule de mémoire à semi-conducteur conforme à la revendication 1, caractérisée en ce que les injecteurs (I1, I2 . . . In) de la cellule de mémoire peuvent être excités par le trajet source-drain d'un transistor de sélection d'injecteur (Tai).

3. Cellule de mémoire à semi-conducteur conforme à la revendication 2, caractérisée en ce que l'électrode de grille du transistor de sélection d'injecteur (Tai) est connectée à une ligne de mot (Z).

4. Cellule de mémoire à semi-conducteur conforme à la revendication 3, caractérisée en ce que les injecteurs (I1, I2 . . . In) sont disposés en série et sont séparés de l'agencement en série des transistors de mémoire (Ts1 . . . Tsn) par une étroite bande d'oxyde de champ.

**FIG.1**

**FIG.2**

**FIG.3**

**FIG.4**

10 µm

0 160 720

FIG.5

FIG.6

10 μm

9